(19) Europäisches Patentamt
European Patent Office
Office européen des brevets

(11) EP 2 837 642 B1

(12) **EUROPEAN PATENT SPECIFICATION**

(45) Date of publication and mention of the grant of the patent:
**09.05.2018 Bulletin 2018/19**

(51) Int Cl.:
***C08F 230/02*** *(2006.01)* ***C08F 2/48*** *(2006.01)*
***C08F 230/08*** *(2006.01)* ***H01L 33/52*** *(2010.01)*

(21) Application number: **14177801.9**

(22) Date of filing: **21.07.2014**

(54) **PHOTOCURABLE COMPOSITION AND ENCAPSULATED APPARATUS PREPARED USING THE SAME**

LICHTHÄRTBARE ZUSAMMENSETZUNG UND DAMIT HERGESTELLTE EINGEKAPSELTE VORRICHTUNG

COMPOSITION PHOTODURCISSABLE ET APPAREIL ENCAPSULÉ PRÉPARÉ À L'AIDE DE CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.08.2013 KR 20130095724**

(43) Date of publication of application:
**18.02.2015 Bulletin 2015/08**

(73) Proprietor: **Samsung SDI Co., Ltd.**
**Gyeonggi-do 446-902 (KR)**

(72) Inventors:
- **Lee, Ji Yeon**
  **Gyeonggi-do,**
  **Republic of Korea (KR)**
- **Ko, Sung Min**
  **Gyeonggi-do,**
  **Republic of Korea (KR)**
- **Nam, Seong Ryong**
  **Gyeonggi-do, (KR)**
- **Oh, Se Il**
  **Gyeonggi-do,**
  **Republic of Korea (KR)**
- **Choi, Seung Jib**
  **Gyeonggi-do,**
  **Republic of Korea (KR)**
- **Ha, Kyoung Jin**
  **Gyeonggi-do,**
  **Republic of Korea (KR)**

(74) Representative: **Michalski Hüttermann & Partner Patentanwälte mbB**
**Speditionstraße 21**
**40221 Düsseldorf (DE)**

(56) References cited:
**EP-A1- 2 573 854** **US-A1- 2010 148 666**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 837 642 B1

## Description

### Field of the Invention

The present invention relates to a photocurable composition and an encapsulated apparatus prepared using the same.

### Description of the Related Art

An organic light emitting diode (OLED) has a structure in which a functional organic layer is interposed between an anode and a cathode, and a high-energy exciton is created by recombination of holes injected into the cathode and electrons injected into the anode. The created exciton moves back to a ground state, thereby emitting light within a specific wavelength band. Organic light emitting diodes have merits such as self-luminescence, rapid response time, wide viewing angle, ultra-thin thickness, high image quality, and durability.

However, organic light emitting diodes have problems such as deterioration in performance and lifespan thereof, caused by oxidation of organic materials and/or electrode materials due to moisture or oxygen from outside or due to outgassing inside or outside the light emitting diodes. To overcome such problems, some methods have been proposed, such as coating with a photocurable sealing agent, attachment of a transparent or opaque moisture absorbent, provision of frits to a substrate, on which an organic light emitting part is formed, and the like. For instance, Korean Patent Publication No. 2005-0021054A discloses an organic electroluminescent device and a manufacturing method thereof. Photocurable compositions are interalia known from the US2010/148666 and EP2573854.

### Summary of the Invention

In accordance with one aspect of the present invention, a photocurable composition has A/B of 0.7 kgf/% or more and A of 2.5 kgf or more, when A indicates glass-metal alloy die shear strength (unit: kgf) after curing between a glass substrate and a Ni/Fe alloy and B indicates curing shrinkage (unit: %) represented by Equation 1.

In the sense of the present invention, the die shear strength can be - and according to a preferred embodiment of the present invention is - measured using the method employed under 3. in the experimental section (p. 21).

In the sense of the present invention, the curing shrinkage can be - and according to a preferred embodiment of the present invention is - measured using the method employed under 4. in the experimental section (p. 21).

In accordance with another aspect of the present invention, a composition for encapsulation of an organic light emitting diode may include the photocurable composition set forth above.

In accordance with a further aspect of the present invention, an encapsulated apparatus may include: a member for the apparatus; and a barrier stack formed on the member for the apparatus and including an inorganic barrier layer and an organic barrier layer formed of the photocurable composition set forth above.

### Brief description of the Drawings

FIG. 1 is a sectional view of an encapsulated apparatus according to one embodiment of the present invention.
FIG. 2 is a sectional view of an encapsulated apparatus according to another embodiment of the present invention.
FIG. 3 is a mimetic diagram of a method for measuring adhesive strength.
FIG. 4 shows an NMR result of a monomer of Preparative Example 1, as represented by Formula 10.

### Detailed description of the Invention

As used herein, unless otherwise stated, the term "substituted" means that at least one hydrogen atom among functional groups of the present invention is substituted with a halogen (F, Cl, Br or I), a hydroxyl group, a nitro group, a cyano group, an imino group (=NH, =NR, wherein R is a $C_1$ to $C_{10}$ alkyl group), an amino group (-$NH_2$, -NH(R'), -N(R")(R"'), wherein R', R" and R"' are each independently a $C_1$ to $C_{10}$ alkyl group), an amidino group, a hydrazine or hydrazone group, a carboxyl group, a substituted or unsubstituted $C_1$ to $C_{20}$ alkyl group, a substituted or unsubstituted $C_6$ to $C_{30}$ aryl group, a substituted or unsubstituted $C_3$ to $C_{30}$ cycloalkyl group, a substituted or unsubstituted $C_3$ to $C_{30}$ heteroaryl group, or a substituted or unsubstituted $C_2$ to $C_{30}$ heterocycloalkyl group.

As used herein, the term "hetero" means that a carbon atom is substituted with an atom selected from the group consisting of N, O, S and P. The symbol "*" as used herein means a binding site of an element. The term "(meth)acrylate" refers to acrylates and/or methacrylates.

In accordance with one aspect of the present invention, when A indicates glass-metal alloy die shear strength (unit: kgf) after curing between a glass substrate and a Ni/Fe alloy and B indicates curing shrinkage (unit: %) represented by Equation 1, a photocurable composition has A/B of 0.7 kgf/% or more and A of 2.5 kgf or more.

<Equation 1>

Curing shrinkage=|(Specific gravity of solid photocurable composition after curing)-(Specific gravity of liquid photocurable composition before curing)|/( Specific gravity of liquid photocurable composition before curing)×100

For encapsulation of a member for an apparatus, the photocurable composition is deposited between the member and an inorganic barrier layer, and then cured. The present invention is based on the principle that, when the photocurable composition has a specific range of a ratio of adhesive strength (the strength between a glass substrate and a Ni/Fe alloy) to curing shrinkage and a specific range of adhesive strength between the glass and the Ni/Fe alloy, the encapsulated apparatus may exhibit improved reliability. As used herein, "reliability" is determined by evaluating whether the apparatus encapsulated with the photocurable composition may be driven, after the encapsulated apparatus is left alone at 85°C and 85% RH for 500 hours.

If A/B is less than 0.7 kgf/%, when left alone at 85°C and 85% RH for 500 hours, the apparatus encapsulated with the photocurable composition is not operated well, suffering from deterioration in reliability, and may suffer from deterioration in lifespan due to severe damage to the member for the apparatus. If A is less than 2.5 kgf, when left alone at 85°C and 85% RH for 500 hours, the apparatus encapsulated with the photocurable composition is not operated well, suffering from deterioration in reliability, and may suffer from deterioration in lifespan due to severe damage to the member for the apparatus.

For example and according to a preferred embodiment of the present invention, the photocurable composition according to the present invention may have A/B from 1.0 kgf/% or higher, preferably 1.1 kgf/% or higher to 2 kgf/% or lower, preferably 1.5 kgf/% or lower.

According to a preferred embodiment of the present invention A is from 2.5 kgf or higher, preferably 5 kgf or higher, most preferred 9 kgf or higher to 15 kgf or lower, preferably 11 kgf or lower. Thus, even when left alone at 85°C and 85% RH for 500 hours, the apparatus encapsulated with the photocurable composition may be operated well and thus exhibits high reliability.

Specific gravity of the liquid photocurable composition before curing and specific gravity of the solid photocurable composition obtained after curing under curing conditions of irradiation at a radiant exposure of 1000 mJ/cm$^2$ for 10 seconds using a light source at a wavelength of 375 nm are measured using an electronic gravimeter (DME-220E, Shinko Co., Ltd., Japan) to calculate curing shrinkage according to Equation 1. To measure the specific gravity of the solid photocurable composition, the photocurable composition is coated to a thickness of 10 $\mu$m$\pm$2 $\mu$m, followed by curing, thereby preparing a film having a thickness from 8 $\mu$m to 12 $\mu$m, a width from 1.5 cm to 2.5 cm and a length from 1.5 cm to 2.5 cm. Next, specific gravity is measured on the prepared film.

As one example of adhesive strength under severe conditions in which low adhesive strength may be measured, adhesive strength of a cured product of the photocurable composition formed between the Ni/Fe alloy and the glass substrate is measured. In one embodiment, adhesive strength refers to strength at which a glass substrate and an 42% by weight (wt%) nickel-containing Ni/Fe alloy (about 42 wt% of Ni+about 58 wt% of Fe) are bonded to each other. FIG. 3 shows a final specimen for measurement of adhesive strength, and a mimetic diagram of measurement of adhesive strength using the final specimen. Referring to FIG. 3, to prepare the specimen for measurement of adhesive strength(e.g., shear die strength), 0.01 g of the photocurable composition is coated to a thickness of 10 $\mu$m onto a lower side of a glass substrate 1 having a size of 5 mm$\times$5 mm$\times$2 mm (width$\times$length$\times$height). A 42 wt% Ni-containing Ni/Fe alloy substrate 2 having a size of 20 min$\times$80 mm$\times$2 mm (width$\times$length$\times$height) was stacked on a lower side of the photocurable composition coating layer, followed by exposure to light at a radiant exposure of 1000 mJ/cm$^2$ for 10 seconds using a light source at a wavelength of 375 nm. As such, a specimen including a cured product 3 of the photocurable composition between the glass substrate 1 and the 42 wt% Ni-containing Ni/Fe alloy substrate 2 was prepared. The adhesive strength(e.g., shear die strength) was measured on the specimen using a Dage 4000 bond tester (Nordson Co., Ltd.). Referring to FIG. 3, a die contact tool 4 of the Dage 4000 bond tester, load against and contact with the edge of the glass substrate 1 and the cured product 3 of the specimen. A contact angle between the die contact tool 4 and the edge of the specimen is almost perpendicular to the plane of the specimen. The adhesive strength(e.g., shear die strength) based on a measure of force applied to the specimen by the die contact tool 4. A direction of the applied force is parallel with the plane of specimen.

To secure the above ranges of A/B and A, the photocurable composition may include: (A1) a photocurable

monomer containing phosphorus (P) and silicon (hereinafter, referred to as (A1) a photocurable monomer); (A2) a photocurable monomer, which is free from phosphorus (P) and silicon and contains an aromatic group (hereinafter, referred to as (A2) a photocurable monomer); and (A3) a photocurable monomer free from phosphorus (P), silicon and an aromatic group (hereinafter, referred to as (A3) a photocurable monomer).

(A1) Photocurable monomer

The (A1) photocurable monomer may be included in the photocurable composition. In this case, the photocurable composition may exhibit improved adhesive strength to the inorganic barrier layer and exhibit reduced curing shrinkage after curing, and the encapsulated apparatus may exhibit improved reliability. The (A1) photocurable monomer may include a vinyl group or a (meth)acrylate group as a photocurable functional group. In one embodiment, the (A1) photocurable monomer may be represented by Formula 1:

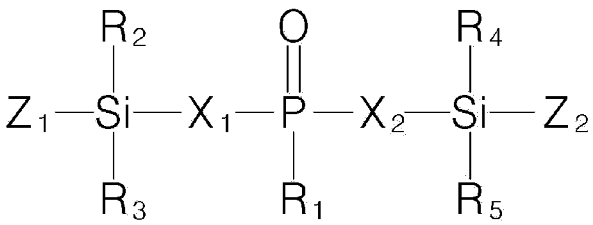

--- (1),

wherein Formula 1, $X_1$ and $X_2$ are each independently oxygen, sulfur, or -NR-(where R is hydrogen or a $C_1$ to $C_{10}$ alkyl group);

$R_1$, $R_2$, $R_3$, $R_4$ and $R_5$ are each independently a substituted or unsubstituted $C_1$ to $C_{10}$ alkyl group, a substituted or unsubstituted $C_6$ to $C_{20}$ aryl group, a substituted or unsubstituted $C_3$ to $C_{10}$ cycloalkyl group, or a substituted or unsubstituted $C_7$ to $C_{21}$ arylalkyl group;

$Z_1$ and $Z_2$ are each independently hydrogen, a substituted or unsubstituted $C_1$ to $C_{10}$ alkyl group, a substituted or unsubstituted $C_6$ to $C_{20}$ aryl group, a substituted or unsubstituted $C_3$ to $C_{10}$ cycloalkyl group, a substituted or unsubstituted $C_7$ to $C_{21}$ arylalkyl group, or a group represented by Formula 2:

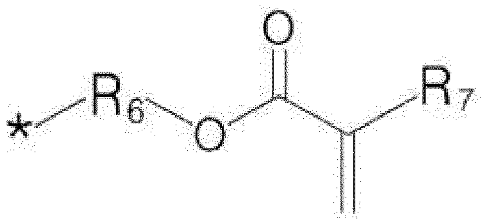

--- (2),

wherein Formula 2, "*" represents a binding site for Si, $R_6$ is a substituted or unsubstituted $C_1$ to $C_{10}$ alkylene group, a substituted or unsubstituted $C_6$ to $C_{20}$ arylene group, a substituted or unsubstituted $C_3$ to $C_{10}$ cycloalkylene group or a substituted or unsubstituted $C_7$ to $C_{21}$ arylalkylene group, and R7 is hydrogen or a methyl group; and

at least one of $Z_1$ and $Z_2$ is the group represented by Formula 2.

For example, $X_1$ and $X_2$ may be each independently oxygen; $R_1$ may be a $C_6$ to $C_{10}$ aryl group or a $C_7$ to $C_{15}$ arylalkyl group; $R_2$, $R_3$, $R_4$ and $R_5$ may be each independently a $C_1$ to $C_5$ alkyl group; and $R_6$ may be a $C_1$ to $C_{10}$ alkylene group.

The monomer represented by Formula 1 may be prepared by any typical method. For example, the monomer represented by Formula 1 may be prepared by reacting a (meth)acryloyl halide with a compound represented by Formula 3:

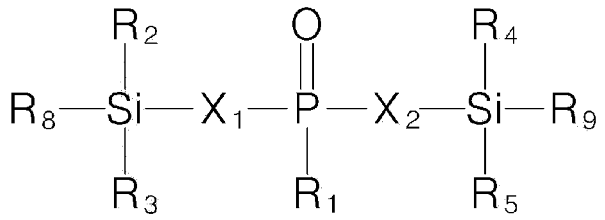

--- (3),

wherein Formula 3, $X_1$, $X_2$, $R_1$, $R_2$, $R_3$, $R_4$ and $R_5$ are defined as in Formula 1; $R_8$ and $R_9$ are hydrogen, a substituted or unsubstituted $C_1$ to $C_{10}$ alkyl group, a substituted or unsubstituted $C_6$ to $C_{20}$ aryl group, a substituted or unsubstituted $C_3$ to $C_{10}$ cycloalkyl group, a substituted or unsubstituted $C_7$ to $C_{21}$ arylalkyl group, or $-R_6$-OH; $R_6$ is defined as in Formula 2; and at least one of $R_8$ and $R_9$ is $-R_6$-OH.

Reaction of the compound represented by Formula 3 with the (meth)acryloyl halide may be performed at 0°C to 20°C in the presence of an organic solvent (for example, methylene chloride) and a basic compound (for example, triethylamine), without being limited thereto. The compound represented by Formula 3 may be prepared by any typical method. For example, the compound in which both $R_8$ and $R_9$ are $-R_6$-OH in Formula 3 may be prepared by reacting an unsaturated alcohol having a terminal double bond (for example, allyl alcohol) with a compound represented by Formula 4:

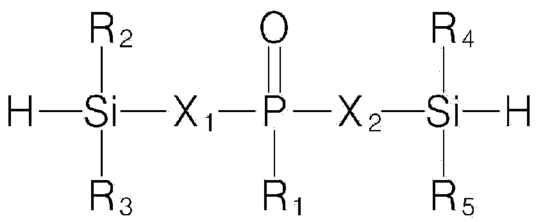

--- (4),

wherein Formula 4, $X_1$, $X_2$, $R_1$, $R_2$, $R_3$, $R_4$ and $R_5$ are defined as in Formula 1.

The (A1) photocurable monomer may be present in an amount of 1 wt% or larger to 50 wt% or less, for example, 4 wt% or larger to 30 wt% or less, in the photocurable composition in terms of solid content. Within this range, the above ranges of A/B and A may be achieved and the encapsulated apparatus does not suffer from deterioration in reliability upon encapsulation.

The (A1) photocurable monomer may be present in an amount of 1 wt% or larger to 50 wt% or less, for example, 5 wt% or larger to 30 wt% or less, based on the total weight of the (A1)+(A2)+(A3) photocurable monomers. Within this range, the above ranges of A/B and A may be achieved and the encapsulated apparatus does not suffer from deterioration in reliability upon encapsulation.

(A2) Photocurable monomer

The (A2) photocurable monomer is a non-phosphorus and non-silicon monomer, which is free from phosphorus (P) and silicon, has an aromatic group, and includes a vinyl group or a (meth)acrylate group as a photocurable functional group. In one embodiment, the (A2) photocurable monomer may be represented by Formula 5:

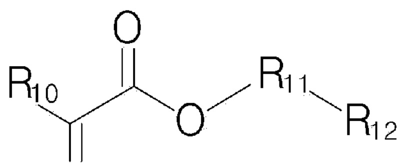

--- (5),

Wherein Formula 5, $R_{10}$ is hydrogen or a methyl group; $R_{11}$ is a substituted or unsubstituted $C_1$ to $C_{10}$ aliphatic hydrocarbon group; and $R_{12}$ is a substituted or unsubstituted $C_6$ to $C_{40}$ aromatic hydrocarbon group.

For example, $R_{11}$ may be a $C_1$ to $C_{10}$ alkylene group or a $C_3$ to $C_{10}$ cycloalkylene group; and $R_{12}$ may be a $C_6$ to $C_{20}$ aryl group, or a $C_1$ to $C_{10}$ alkyl group-substituted or $C_6$ to $C_{20}$ aryl group-substituted $C_6$ to $C_{20}$ aryl group.

The (A2) photocurable monomer may be prepared by any typical method, or may be commercially available.

The (A2) photocurable monomer may be present in an amount of 1 wt% or larger to 50 wt% or less, for example, 5 wt% or larger to 20 wt% or less in the photocurable composition in terms of solid content. Within this range, the above ranges of A/B and A may be achieved and the encapsulated apparatus does not suffer from deterioration in reliability upon encapsulation.

The (A2) photocurable monomer may be present in an amount of 1 wt% or larger to 50 wt% or less, for example, 10 wt% or larger to 20 wt% or less based on the total weight of (A1)+(A2)+(A3) photocurable monomers. Within this range, the above ranges of A/B and A may be achieved and the encapsulated apparatus does not suffer from deterioration in reliability upon encapsulation.

<u>(A3) Photocurable monomer</u>

The (A3) photocurable monomer is a non-phosphorus, non-silicon and nonaromatic monomer, which is free from phosphorus (P), silicon and an aromatic group, and may include a vinyl group or a (meth)acrylate group as a photocurable functional group.

The (A3) photocurable monomer may include a mixture of a monofunctional monomer and a polyfunctional monomer. In in the mixture, the monofunctional monomer and the polyfunctional monomer may be present in a weight ratio from 1:0.1 or larger to 1:4 or less, for example, from 1:1 to 1:4 or larger or less, for example, from 1:2 or larger to 1:4 or less.

The (A3) photocurable monomer may include: unsaturated carboxylic acid esters containing a $C_1$ to $C_{20}$ alkyl group, a $C_3$ to $C_{20}$ cycloalkyl group, or a hydroxyl group; $C_1$ to $C_{20}$ aminoalkyl group-containing unsaturated carboxylic acid esters; vinyl esters of $C_1$ to $C_{20}$ saturated or unsaturated carboxylic acids; vinyl cyanide compounds; unsaturated amide compounds; monofunctional or polyfunctional (meth)acrylates of monohydric or polyhydric alcohols, or the like. The term "polyhydric alcohol" refers to alcohols containing two or more hydroxyl groups, for example, polyhydric alcohol containing 2 to 20 hydroxyl groups, 2 to 10 hydroxyl groups, or 2 to 6 hydroxyl groups.

In one embodiment, the (A3) photocurable monomer may include: unsaturated carboxylic acid esters including (meth)acrylic acid esters, such as methyl (meth)acrylate, ethyl (meth)acrylate, butyl (meth)acrylate, 2-hydroxyethyl (meth)acrylate, 2-hydroxybutyl (meth)acrylate, hexyl (meth)acrylate, octyl (meth)acrylate, nonyl (meth)acrylate, decanyl (meth)acrylate, undecanyl (meth)acrylate, dodecyl (meth)acrylate, cyclohexyl (meth)acrylate, or the like; unsaturated carboxylic acid aminoalkyl esters, such as 2-aminoethyl (meth)acrylate, 2-dimethylamino ethyl (meth)acrylate, and the like; saturated or unsaturated carboxylic acid vinyl esters, such as vinyl acetate, and the like; vinyl cyanide compounds, such as (meth)acrylonitrile, and the like; unsaturated amide compounds, such as (meth)acrylamide, and the like; and monofunctional or polyfunctional (meth)acrylates of monohydric or polyhydric alcohols, such as ethylene glycol di(meth)acrylate, triethylene glycol di(meth)acrylate, trimethylolpropane tri(meth)acrylate, 1,4-butanediol di(meth)acrylate, 1,6-hexanediol di(meth)acrylate, octanediol di(meth)acrylate, nonanediol di(meth)acrylate, decanediol di(meth)acrylate, undecanediol di(meth)acrylate, dodecanediol di(meth)acrylate, neopentyl glycol di(meth)acrylate, pentaerythritol di(meth)acrylate, pentaerythritol tri(meth)acrylate, pentaerythritol tetra(meth)acrylate, dipentaerythritol di(meth)acrylate, dipentaerythritol tri(meth)acrylate, dipentaerythritol tetra(meth)acrylate, dipentaerythritol penta(meth)acrylate, dipentaerythritol hexa(meth)acrylate, diethylene glycol di(meth)acrylate, tri(propylene glycol) di(meth)acrylate, poly(propylene glycol) di(meth)acrylate, and the like, without being limited thereto. For example, the (A3) photocurable monomer may include at least one of $C_1$ to $C_{20}$ alkyl-group containing (meth)acrylates, $C_2$ to $C_{20}$ diol di(meth)acrylates, $C_3$ to $C_{20}$ triol tri(meth)acrylates, and $C_4$ to $C_{20}$ tetraol tetra(meth)acrylates. For example, the (A3) photocurable monomer is a polyalkylene glycol di(meth)acrylate and may include a $C_2$ to $C_5$ linear or branched alkylene glycol unit-containing di(meth)acrylate.

The (A3) photocurable monomer may be present in an amount of 1 wt% or larger to 97 wt% or less, for example, 10 wt% or larger to 90 wt% or less, for example, 45 wt% or larger to 80 wt% or less, in the photocurable composition in terms of solid content. Within this range, the above ranges of A/B and A may be achieved and the encapsulated apparatus does not suffer from deterioration in reliability upon encapsulation.

The (A3) photocurable monomer may be present in an amount of 1 wt% to 98 wt% or less, for example, 10 wt% or larger to 90 wt% or less, for example, 50 wt% or larger to 80 wt% or less, based on total weight of (A1)+(A2)+(A3) photocurable monomers. Within this range, the above ranges of A/B and A may be achieved and the encapsulated apparatus does not suffer from deterioration in reliability upon encapsulation.

In the photocurable composition, a weight ratio of the (A2) photocurable monomer to the (A1) photocurable monomer may range from 0.6 or larger to 4 or less, a weight ratio of the (A3) photocurable monomer to the (A1) photocurable monomer may range from 1 or larger to 25 or less, and a weight ratio of the (A3) photocurable monomer to the (A2) photocurable monomer may range from 2.5 or larger to 8 or less. Within this range, the encapsulated apparatus

may exhibit high reliability.

The photocurable composition may further include an initiator. Here, the initiator may include a photopolymerization initiator. The photopolymerization initiator may include any typical photopolymerization initiators capable of performing photocuring reaction without limitation. For example, the photopolymerization initiator may include triazine, acetophenone, benzophenone, thioxanthone, benzoin, phosphorus, oxime initiators, or mixtures thereof.

Examples of the triazine initiators may include 2,4,6-trichloro-s-triazine, 2-phenyl-4,6-bis(trichloromethyl)-s-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(p-tolyl)-4,6-bis(trichloromethyl)-s-triazine, 2-biphenyl-4,6-bis(trichloromethyl)-s-triazine, 2,4-bis(trichloromethyl)-6-styryl-s-triazine, 2-(naphtho-1-yl)-4,6-bis(trichloromethyl)-s-triazine, 2-(4-methoxynaphtho-1 -yl)-4,6-bis(trichloromethyl)-s-triazine, 2,4-trichloromethyl(piperonyl)-6-triazine, 2,4-(trichloromethyl(4'-methoxy styryl)-6-triazine, or mixtures thereof. Examples of the acetophenone initiators may include 2,2'-diethoxyacetophenone, 2,2'-dibuthoxyacetophenone, 2-hydroxy-2-methyl propiophenone, p-t-butyl trichloroacetophenone, p-t-butyl dichloroacetophenone, 4-chloroacetophenone, 2,2'-dichloro-4-phenoxyacetophenone, 2-methyl-1-(4-(methylthio)phenyl)-2-morpholinopropan-1-one, 2-benzyl-2-dimethylamino-1-(4-morpholinophenyl)-butan-1-one, or mixtures thereof. Examples of the benzophenone initiators may include benzophenone, benzoyl benzoate, methyl benzoylbenzoate, 4-phenyl benzophenone, hydroxybenzophenone, acrylated benzophenone, 4,4'-bis(dimethylamino)benzophenone, 4,4'-dichlorobenzophenone, 3,3'-dimethyl-2-methoxybenzophenone, or mixtures thereof. Examples of the thioxanthone initiators may include thioxanthone, 2-methyl thioxanthone, isopropyl thioxanthone, 2,4-diethyl thioxanthone, 2,4-diisopropyl thioxanthone, 2-chlorothioxanthone, or mixtures thereof. Examples of the benzoin initiators may include benzoin, benzoin methyl ether, benzoin ethyl ether, benzoin isopropyl ether, benzoin isobutyl ether, benzyl dimethyl ketal, or mixtures thereof. Examples of the phosphorus initiators may include diphenyl(2,4,6-trimethylbenzoyl)phosphine oxide, or mixtures thereof. Examples of the oxime initiators may include 2-(o-benzoyloxime)-1-[4-(phenylthio)phenyl]-1,2-octanedione, 1-(o-acetyloxime)-1-[9-ethyl-6-(2-methylbenzoyl)-9H-carbazole-3-yl]ethanone, or mixtures thereof.

The initiator may be present in an amount of 0.1 wt% to 10 wt%, for example, 1 wt% to 10 wt%, 1 wt% to 8 wt% or 1 wt% to 5 wt%, in the photocurable composition in terms of solid content. Within this range, the photocurable composition allows sufficient photopolymerization under exposure to light, and may be prevented from deterioration in transmittance due to unreacted initiator remaining after photopolymerization.

The initiator may be present in an amount of 1 part by weight to 10 parts by weight, for example, 1 part by weight to 5 parts by weight, based on 100 parts by weight of the (A1)+(A2)+(A3) photocurable monomers. Within this range, the photocurable composition allows sufficient photopolymerization under exposure to light and may be prevented from deterioration in transmittance due to the unreacted initiator remaining after photopolymerization.

The photocurable composition may be formed by mixing the photocurable monomers and the initiator. The photocurable composition may be formed as a solvent-free photocurable composition.

The photocurable composition may have a degree of curing of 90% or more, for example, from 90% or more to 99% or less, for example, from 93% or more to 98.5% or less. Within this range, the photocurable composition realizes a layer not suffering from a shift due to low curing shrinkage stress after curing, thereby allowing the photocurable composition to be used for encapsulation of devices.

The photocurable composition may have a curing shrinkage from 1% or higher to 10% or lower, for example and according to a preferred embodiment of the present invention, from 7% or higher to 9% or lower, as represented by Equation 1. Within this range, the photocurable composition realizes a layer not suffering from a shift due to low curing shrinkage stress after curing, thereby allowing the photocurable composition to be used for encapsulation of devices.

The member for the apparatus, particularly the member for displays, may suffer from degradation or deterioration in quality due to permeation of gas or liquid in a surrounding environment, for example, atmospheric oxygen and/or moisture and/or water vapor and due to permeation of chemicals used in the preparation of electronic products. To prevent this problem, the member for the apparatus needs to be sealed or encapsulated.

The member for the apparatus may include organic light emitting diodes (OLEDs), illumination devices, metal sensor pads, microdisc lasers, electrochromic devices, photochromic devices, microelectromechanical systems, solar cells, integrated circuits, charge coupled devices, light emitting diodes, or the like, without being limited thereto. The organic light emitting diodes may include a flexible organic light emitting diode or the like.

The photocurable composition may form an organic barrier layer used for sealing or encapsulation of the member for the apparatus, particularly organic light emitting diodes or flexible organic light emitting diodes, and a composition for encapsulation of an organic light emitting diode may include the photocurable composition.

According to the present invention, the organic barrier layer may be formed of the photocurable composition. In one embodiment, the organic barrier layer may be formed by photocuring of the photocurable composition. The organic barrier layer may be prepared by coating the photocurable composition to a thickness from 0.1 μm or more to 20 μm or less, specifically from 1 μm or more to 10 μm or less, followed by curing the photocurable composition through

irradiation at 10 $mW/cm^2$ to 500 $mW/cm^2$ for 1 second to 50 seconds, without being limited thereto.

Since the organic barrier layer exhibits low water vapor transmission rate and outgassing, and has high adhesive strength to an inorganic barrier layer, the organic barrier layer and the inorganic barrier layer described below form a barrier stack, and thus can be used for encapsulation of the member for the apparatus. In one embodiment, the organic barrier layer may have a water vapor transmission rate of 4.0 $g/m^2 \cdot 24hr$ or less, as measured on a 5 $\mu m$ thick coating layer at 37.8°C and 100% RH for 24 hours. Within this range, the organic barrier layer may be used for encapsulation of the member for the apparatus. For example, the organic barrier layer may have a water vapor transmission rate from 1.0 $g/m^2 \cdot 24hr$ to 4.0 $g/m^2 \cdot 24hr$, for example, from 2.5 $g/m^2 \cdot 24hr$ to 3.2 $g/m^2 \cdot 24hr$. In one embodiment, the organic barrier layer may have an outgassing amount of 2000 ppm or less. Within this range, the organic barrier layer has an insignificant side effect of outgassing on the member for the apparatus, and the member for the apparatus has long lifespan. Specifically, the organic barrier layer may have an outgassing amount of 1000 ppm or less, more specifically from 10 ppm to 1000 ppm. In one embodiment, the organic barrier layer may have an adhesive strength to the inorganic barrier layer of 2.5 kgf or more, for example, from 2.5 kgf to 11 kgf. Within this range, the encapsulated apparatus may exhibit improved reliability.

According to the invention, the barrier stack may include the organic and inorganic barrier layers. The inorganic barrier layer includes different components from those of the organic barrier layer, thereby supplementing the effects of the organic barrier layer.

The inorganic barrier layer may be any inorganic barrier layer without limitation so long as the inorganic barrier layer may exhibits excellent light transmittance and excellent moisture and/or oxygen barrier properties. For example, the inorganic barrier layer may include at least one selected from among metals; nonmetals; oxides of metals, nonmetals or mixtures thereof; fluorides of metals, nonmetals or mixtures thereof; nitrides of metals, nonmetals or mixtures thereof; carbides of metals, nonmetals or mixtures thereof; oxynitrides of metals, nonmetals or mixtures thereof; borides of metals, nonmetals or mixtures thereof; silicides of metals, nonmetals or mixtures thereof; alloys of at least two metals; or alloys of metals and nonmetals. The metals may include post transition metals, metalloids, transition metals, lanthanide metals, or the like, without being limited thereto. For example, the metals may include silicon, aluminum, iron, nickel or the like, and the inorganic barrier layer may be silicon oxide, silicon nitride, silicon oxynitride, ZnSe, ZnO, $Sb_2O_3$, $Al_2O_3$, $In_2O_3$, or $SnO_2$.

The organic barrier layer may secure the aforementioned water vapor transmission rate, outgassing amount, and adhesive strength. As a result, when the organic and inorganic barrier layers are alternately deposited, the inorganic barrier layer may secure smoothness. In addition, the organic barrier layer may prevent defects of the inorganic barrier layer from spreading to other inorganic barrier layers.

The barrier stack may include any number of organic and inorganic barrier layers. Combination of the organic and inorganic barrier layers may vary with a level of permeation resistance to oxygen and/or moisture and/or water vapor and/or chemicals.

The organic and inorganic barrier layers may be alternately deposited. This is because that the aforementioned composition has an effect on the organic barrier layer due to the properties thereof. As a result, the organic and inorganic barrier layers may supplement or reinforce encapsulation of the member for the apparatus. For example, the organic and inorganic layers may be alternately formed in two or more layers, respectively. In addition, the organic and inorganic layers are formed in a total of 10 layers or less (for example, 2 layers to 10 layers), preferably in a total of 7 layers or less (for example, 2 layers to 7 layers).

In the barrier stack, one organic barrier layer may have a thickness from 0.1 $\mu m$ to 20 $\mu m$, for example, from 1 $\mu m$ to 10 $\mu m$, and one inorganic barrier layer may have a thickness from 5 nm to 500 nm, for example, from 5 nm to 50 nm. The barrier stack is a thin film encapsulant and may have an encapsulation thickness of 5 $\mu m$ or less, for example, from 1.5 $\mu m$ to 5 $\mu m$. Within this range, the barrier stack may be used for encapsulation of the member for the apparatus. The inorganic barrier layer may be formed by a vacuum process, for example, sputtering, chemical vapor deposition, plasma chemical vapor deposition, evaporation, sublimation, electron cyclotron resonance-plasma enhanced chemical vapor deposition, or combinations thereof. The organic barrier layer may be deposited using the same method as in the inorganic barrier layer, or be formed by coating the photocurable composition, followed by curing.

In accordance with a further aspect of the present invention, an encapsulated apparatus may include a member for the apparatus and inorganic and organic barrier layers formed on the member for the apparatus, wherein the organic barrier layer may be formed of the above photocurable composition.

The organic barrier layer may be formed on an upper or lower side of the inorganic barrier layer, and the inorganic barrier layer may be formed on an upper side of the member for the apparatus, an upper side of the organic barrier layer, or a lower side of the organic barrier layer. As such, since the encapsulated apparatus allows the member for the apparatus to be encapsulated by the inorganic and organic barrier layers exhibiting different properties from each other, the inorganic and organic barrier layers may supplement or reinforce encapsulation of the member for the apparatus.

Each of the inorganic and organic barrier layers may be included in multiple layers such as two layers or more

in the encapsulated apparatus. In one embodiment, the inorganic and organic barrier layers may be deposited alternately, for example, in order of inorganic barrier layer/organic barrier layer/inorganic barrier layer/organic barrier layer. Preferably, the inorganic and organic barrier layers are included in a total of 10 layers or less (for example, 2 layers to 10 layers), more preferably in a total of 7 layers or less (for example, 2 layers to 7 layers).

Details of the organic and inorganic barrier layers are as described above.

At least one of the organic and inorganic barrier layers may be coupled to a substrate in order to encapsulate devices, and the member for the apparatus may include the substrate depending upon kinds thereof. The substrate may be any substrate so long as the member for the apparatus may be stacked on the substrate. For example, the substrate may include transparent glass substrates, plastic sheets, silicon substrates, metal substrates, or the like.

FIG. 1 is a sectional view of an encapsulated apparatus according to one embodiment of the present invention. Referring to FIG. 1, an encapsulated apparatus 100 includes a substrate 10, a member for the apparatus 20 formed on the substrate 10, and a barrier stack 30 formed on the member for the apparatus 20. The barrier stack 30 including an inorganic barrier layer 31 and an organic barrier layer 32, wherein the inorganic barrier layer 31 is in contact with the member for the apparatus 20.

FIG. 2 is a sectional view of an encapsulated apparatus according to another embodiment of the present invention. Referring to FIG. 2, an encapsulated apparatus 200 includes a substrate 10, a member for the apparatus 20 formed on the substrate 10, and a barrier stack 30 which is formed on the member for the apparatus 20 and includes an inorganic barrier layer 31 and an organic barrier layer 32, wherein the inorganic barrier layer 31 encapsulates an interior space 40 in which the member for the apparatus 20 is received.

Although each of the inorganic and organic barrier layers is illustrated as being formed in a single layer in FIGs. 1 and 2, each of the inorganic and organic barrier layers may be formed in multiple layers. In addition, the encapsulated apparatus may further include a sealant and/or a substrate on a lateral side and/or an upper side of the composite barrier layer including the inorganic and organic barrier layers (not shown in FIGs. 1 and 2).

The encapsulated apparatus may be prepared by any typical method. The member for the apparatus is formed on the substrate, followed by forming an inorganic barrier layer on the member for the apparatus. The photocurable composition is coated to a desired thickness, for example, of 1 μm to 5 μm, using spin coating, slit coating, or the like, followed by irradiation to form an organic barrier layer. The procedure of forming the inorganic and organic barrier layers may be repeated (for example, such that the inorganic and organic barrier layers are formed in a total of 10 layers or less). In one embodiment, the encapsulated apparatus may include an organic light emitting display including an organic light emitting part, a display such as a liquid crystal display, a solar cell, or the like, without being limited thereto.

**Preparative Example 1: Preparation of monomer represented by Formula 10**

**Operation 1:** A monomer represented by Formula 6 was prepared according to Reaction Formula 1. Specifically, 34.42 g of 1,1,3,3-tetramethyldisiloxane (represented by Formula 8 according to Reaction Formula 1, Aldrich Co., Ltd.), 2.7 g of water, and 41.67 g of methylene chloride were placed in a 1000 ml flask provided with a cooling tube and a stirrer, followed by stirring at room temperature. Next, the temperature of the flask was lowered to 0°C, followed by slowly introducing 10 g of phenylphosphonic dichloride (represented by Formula 7 according to Reaction Formula 1, Aldrich Co., Ltd.) into the flask. Next, reaction was performed at room temperature, thereby preparing the monomer represented by Formula 6 according to Reaction Formula 1. The obtained monomer represented by Formula 6 had a purity of 98% as determined by HLPC.

<Reaction Formula 1>

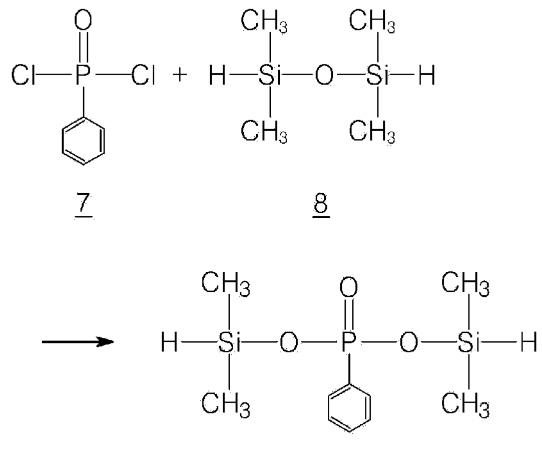

7 8

6

**Operation 2:** 100 g of ethyl acetate, 34.25 g of the monomer (represented by Formula 6_according to Reaction Formula 1) obtained in Operation 1, 29 g of allyl alcohol (Aldrich Co., Ltd.), and a platinum(0)-1,3-divinyl-1,1,3,3 tetramethyldisiloxane complex (Aldrich Co., Ltd.) as a Pt catalyst were placed in a 1000 ml flask provided with a cooling tube and a stirrer, followed by reflux at 80°C for 4 hours. Next, ethyl acetate was removed, thereby obtaining a compound represented by Formula 9.

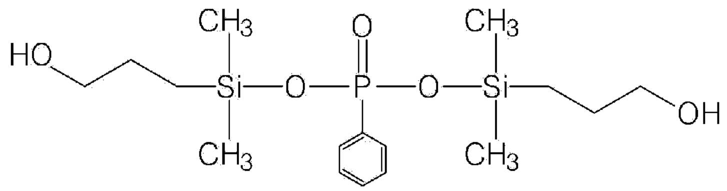

--- (Formula 9)

**Operation 3:** 100 g of methylene chloride, 47.25 g of the compound represented by Formula 9 and obtained in Operation 2, and 21.2 g of acryloyl chloride were placed in a 1000 ml flask provided with a cooling tube and a stirrer, followed by stirring. Next, the temperature of the flask was lowered to 0°C, followed by slowly introducing 27.8 g of triethylamine into the flask. Next, reaction was performed at room temperature for 4 hours, thereby obtaining a compound represented by Formula 10. It was confirmed from the result of 1H-NMR of FIG. 4 that the obtained compound was the compound represented by Formula 10.

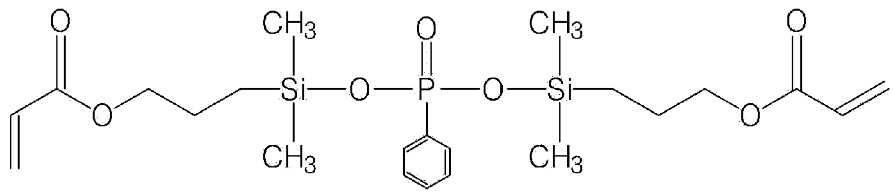

---

(Formula 10)

**Preparative Example 2: Preparation of monomer represented by Formula 11**

100 g of methylene chloride, 42.4 g of [1,1'-biphenyl]-4-propanol, and 30.6 g of acryloyl chloride were placed in a 1000 ml flask provided with a cooling tube and a stirrer, followed by stirring. Next, the temperature of the flask was lowered to 0°C, followed by slowly introducing 40.4 g of triethylamine into the flask. Next, reaction was performed at

room temperature for 4 hours, thereby obtaining a compound represented by Formula 11.

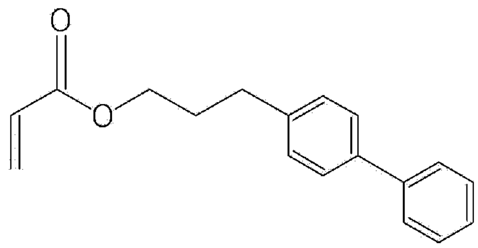

--- (Formula 11)

(1) Photocurable monomer;

(A1) Photocurable monomer: The monomer represented by Formula 10.
(A2) Photocurable monomer: The monomer represented by Formula 11.
(A3) Photocurable monomer: Tetra(ethylene glycol) diacrylate (Aldrich Co., Ltd.) represented by Formula 12.

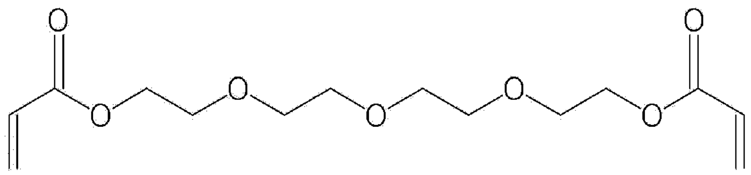

--- (Formula 12)

(2) Initiator: Diphenyl(2,4,6-trimethylbenzoyl)phosphine oxide (TPO, BASF Co., Ltd.) as a photopolymerization initiator.

**Examples 1 to 3 and Comparative Examples 1 to 3**

In a 125 ml brown polypropylene bottle, photocurable monomers and an initiator were placed without solvents in amounts as listed in Table 2, followed by mixing for 3 hours using a shaker, thereby preparing compositions of Examples 1 to 3 and Comparative Examples 1 to 3.

Each of the compositions prepared in Examples and Comparative Examples was evaluated as to the following properties. Results are shown in Table 2.

<u>Evaluation of Properties</u>

1. Water vapor transmission rate: a water vapor transmission rate tester (PERMATRAN-W 3/33, MOCON Co., Ltd.) was used. The photocurable composition was spray-coated onto an A1 sample holder, followed by UV curing through UV irradiation at 100 mW/cm$^2$ for 10 seconds, thereby forming a cured specimen having a coating thickness of 5 μm. Water vapor transmission rate was measured on the 5 μm thick cured specimen at 37.8°C and 100% RH for 24 hours using a water vapor transmission rate tester (PERMATRAN-W 3/33, MOCON Co., Ltd.).
2. Outgassing amount: The photocurable composition was spray-coated onto a glass substrate, followed by UV curing through UV irradiation at 100 mW/cm$^2$ for 10 seconds, thereby obtaining an organic barrier layer specimen having a size of 20 cm×20 cm×3 μm (width×length×thickness). Outgassing amount was measured on the specimen using a GC/MS tester (Perkin Elmer Clarus 600). GC/MS utilized a DB-5MS column (length: 30 m, diameter: 0.25 mm, thickness of stationary phase: 0.25 μm) as a column, and helium gas (flow rate: 1.0 mL/min, average velocity=32 cm/s) as a mobile phase. Further, the split ratio was 20:1, and the specimen was maintained at 40°C for 3 minutes, followed by heating at a rate of 10°C/min and then maintaining at 320°C for 6 minutes. Outgas was collected under the conditions that a glass size was 20 cm×20 cm, a collection container was a Tedlar bag, collection temperature was 90°C, collection time was 30 minutes, $N_2$ purging was supplied at a flow rate of 300 mL/min and Tenax GR (5% phenyl methyl polysiloxane) was used as an adsorbent. A calibration curve was plotted using a toluene solution in n-hexane in a concentration of 150 ppm, 400 ppm and 800 ppm as a standard solution, wherein R2 value for plotting calibration curve was 0.9987. The

above conditions are summarized in Table 1.

Table 1

| Conditions | | Details |
|---|---|---|
| Collection conditions | | Glass size: 20 cm×20 cm |
| | | Collection container : Tedlar bag |
| | | Collection temperature: 90°C |
| | | Collection time: 30 min |
| | | N2 purge flow rate: 300 mL/min |
| | | Adsorbent: Tenax GR (5% phenyl methyl polysiloxane) |
| Conditions for plotting calibration curve | | Standard solution: Toluene in n-hexane |
| | | Concentration range (reference): 150 ppm, 400 ppm, 800 ppm |
| | | R2: 0.9987 |
| GC/MS conditions | Column | DB-5MS→30 m × 0.25 mm × 0.25 μm (5% phenyl methyl polysiloxane) |
| | Mobile phase | He |
| | Flow | 1.0 mL/min (Average velocity = 32 cm/s) |
| | Split | Split ratio = 20:1 |
| | Method | 40°C (3 min) → 10 °C/min → 320°C (6 min) |

3. Adhesive strength (kgf): To measure adhesive strength, 0.01 g of the photocurable composition was coated to a thickness of 10 μm onto a lower side of a glass substrate having a size of 5 mm×5 mm×2 mm (width×length×height). A 42 wt% of Ni-containing Ni/Fe alloy substrate having a size of 20 min×80 mm×2 mm (width×length×height) was stacked on a lower side of the photocurable composition coating layer, followed by exposure to light at a radiant exposure of 1000 mJ/cm$^2$ for 10 seconds using a light source at a wavelength of 375 nm. In this way, a specimen having a cured product (thickness: 10 μm) of the photocurable composition between the glass substrate and the Ni/Fe alloy substrate was prepared.The adhesive strength(e.g., shear die strength) was measured on the prepared specimen using a Dage 4000 bond tester (Nordson Co., Ltd.). Referring to FIG. 3, a die contact tool 4 of the Dage 4000 bond tester, load against and contact with the edge of the glass substrate 1 and the cured product 3 of the specimen. A contact angle between the die contact tool 4 and the edge of the specimen is almost perpendicular to the plane of the specimen. The adhesive strength(e.g., shear die strength) based on a measure of force applied to the specimen by the die contact tool 4. A direction of the applied force is parallel with the plane of specimen.

4. Curing shrinkage (%): Specific gravity of a liquid photocurable composition before curing, and specific gravity of a solid photocurable composition obtained after curing under curing conditions of irradiation at a radiant exposure of 1000 mJ/cm$^2$ for 10 seconds using a light source at a wavelength of 375 nm were measured using an electronic gravimeter (DME-220E, Shinko Co., Ltd., Japan). To measure the specific gravity of the solid photocurable composition, the photocurable composition was coated to a thickness of 10 μm±2 μm, followed by curing under the above conditions, thereby preparing a film having a thickness from 8 μm to 12 μm, a width from 1.5 cm to 2.5 cm and a length from 1.5 cm to 2.5 cm. Next, the obtained values of specific gravity were substituted into Equation 1, thereby calculating curing shrinkage.

5. Reliability: An apparatus encapsulated with the photocurable composition was left alone at 85°C and 85% RH for 500 hours, followed by evaluating whether the encapsulated apparatus was operated well or not(whether an OLED apparatus was operated and whether pixels were damaged, upon power supply). An OLED apparatus exhibiting good reliability since the OLED apparatus was operated and did not suffer from damage of pixels on the screen was rated as "O", and an OLED apparatus exhibiting poor reliability since the OLED apparatus was not operated or suffered from damage of pixels was rated as "X".

Table 2

| | | Example 1 | Example 2 | Example 3 | Comparative Example 1 | Comparative Example 2 | Comparative Example 3 |
|---|---|---|---|---|---|---|---|
| Photocurable monomer (wt%) | (A1) | 30 | 10 | 5 | - | 100 | - |
| | (A2) | 20 | 10 | 20 | - | - | 100 |
| | (A3) | 50 | 80 | 75 | 100 | - | - |
| Initiator (parts by weight) | | 5 | 5 | 5 | 5 | 5 | 5 |
| Water vapor transmission rate ($g/m^2 \cdot 24hr$) | | 2.7 | 2.5 | 3.2 | 3.5 | 12.7 | 7.6 |
| Outgassing amount (ppm) | | 290 | 310 | 350 | 320 | 340 | 1310 |
| Adhesive strength (kgf) (A) | | 10.8 | 9.9 | 9.2 | 8.1 | 5.2 | 2.3 |
| Curing shrinkage (%) (B) | | 7.3 | 8.1 | 7.9 | 13.6 | 7.7 | 3.1 |
| (A)/(B) (kgf/%) | | 1.48 | 1.22 | 1.16 | 0.60 | 0.68 | 0.74 |
| Reliability | | O | O | O | X | X | X |
| Unit of amount of photocurable monomer: wt% based on (A1)+(A2)+(A3)<br>Unit of amount of initiator: parts by weight based on 100 parts by weight of (A1)+(A2)+(A3) | | | | | | | |

As shown in Table 2, it was confirmed that the photocurable composition according to the present invention could realize an encapsulated apparatus exhibiting excellent reliability since the photocurable composition had a ratio of adhesive strength to curing shrinkage of 0.7 kgf/% or more and an adhesive strength of 2.5 kgf or more. Conversely, it was confirmed that the photocurable compositions of Comparative Examples 1 and 2 having a ratio of adhesive strength to curing shrinkage of less than 0.7 kgf/% and the photocurable composition of Comparative Example 3 having an adhesive strength of less than 2.5 kgf provided poor reliability to the encapsulated apparatus.

**Claims**

**1.** A photocurable composition, wherein, when A indicates glass-metal alloy die shear strength (unit: kgf) after curing between a glass substrate and a Ni/Fe alloy and B indicates curing shrinkage (unit: %) represented by Equation 1, the photocurable composition has A/B of 0.7 kgf/% or more and A of 2.5 kgf or more.

<Equation 1>

Curing shrinkage=[(Specific gravity of solid photocurable composition after curing)-(Specific gravity of liquid photocurable composition before curing)]/(Specific gravity of liquid photocurable composition before curing)×100.

and comprising:

(A1) a photocurable monomer containing phosphorus (P) and silicon (Si);
(A2) a photocurable monomer free from phosphorus and silicon, and containing an aromatic group; and
(A3) a photocurable monomer free from phosphorus, silicon and an aromatic group; wherein the shear strength and curing shrinkage are determined as described in the description.

**2.** The photocurable composition according to claim 1, wherein the photocurable composition has a curing shrinkage from 1% or higher to 10% or lower.

**3.** The photocurable composition according to Claim 1 or 2, wherein the (A1) photocurable monomer is represented

by Formula 1:

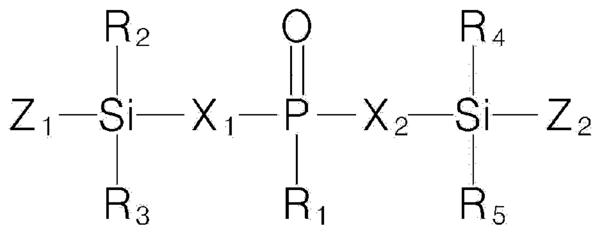

--- (Formula 1),

wherein Formula 1, $X_1$ and $X_2$ are each independently oxygen, sulfur, or -NR-(where R is hydrogen or a $C_1$ to $C_{10}$ alkyl group);
$R_1$, $R_2$, $R_3$, $R_4$ and $R_5$ are each independently a substituted or unsubstituted $C_1$ to $C_{10}$ alkyl group, a substituted or unsubstituted $C_6$ to $C_{20}$ aryl group, a substituted or unsubstituted $C_3$ to $C_{10}$ cycloalkyl group, or a substituted or unsubstituted $C_7$ to $C_{21}$ arylalkyl group;
$Z_1$ and $Z_2$ are each independently hydrogen, a substituted or unsubstituted $C_1$ to $C_{10}$ alkyl group, a substituted or unsubstituted $C_6$ to $C_{20}$ aryl group, a substituted or unsubstituted $C_3$ to $C_{10}$ cycloalkyl group, a substituted or unsubstituted $C_7$ to $C_{21}$ arylalkyl group, or a group represented by Formula 2:

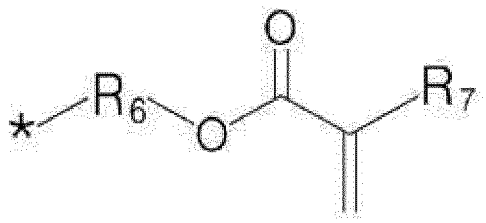

--- (Formula 2),

wherein "*" represents a binding site for Si, $R_6$ is a substituted or unsubstituted $C_1$ to $C_{10}$ alkylene group, a substituted or unsubstituted $C_6$ to $C_{20}$ arylene group, a substituted or unsubstituted $C_3$ to $C_{10}$ cycloalkylene group or a substituted or unsubstituted $C_7$ to $C_{21}$ arylalkylene group, and R7 is hydrogen or a methyl group; and at least one of $Z_1$ and $Z_2$ is the group represented by Formula 2.

4. The photocurable composition according to any of the claims 1 to 3, wherein the (A2) photocurable monomer is represented by Formula 5:

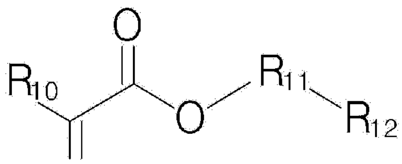

--- (Formula 5),

wherein Formula 5, $R_{10}$ is hydrogen or a methyl group; $R_{11}$ is a substituted or unsubstituted $C_1$ to $C_{10}$ aliphatic hydrocarbon group; and $R_{12}$ is a substituted or unsubstituted $C_6$ to $C_{40}$ aromatic hydrocarbon group.

5. The photocurable composition according to any of the claims 1 to 4, wherein the (A3) photocurable monomer comprises a polyalkylene glycol di(meth)acrylate.

6. The photocurable composition according to any of the claims 1 to 5, wherein the photocurable composition comprises: 1 wt% to 50 wt% of the (A1) photocurable monomer; 1 wt% to 50 wt% of the (A2) photocurable monomer; and 1 wt% to 90 wt% of the (A3) photocurable monomer.

7. The photocurable composition according to any of the claims 1 to 6, further comprising: (B) an initiator.

**8.** The photocurable composition according any of the claims 1 to 7, wherein the photocurable composition comprises: 1 wt% to 50 wt% of the (A1) photocurable monomer; 1 wt% to 50 wt% of the (A2) photocurable monomer; 1 wt% to 97 wt% of the (A3) photocurable monomer; and 0.1 wt% to 10 wt% of the (B) initiator.

**9.** The photocurable composition according any of the claims 1 to 8, wherein the photocurable composition has a water vapor transmission rate of 4.0 $g/m^2 \cdot 24hr$ or less, as measured on a 5 $\mu m$ thick coating layer at 37.8°C and 100% RH for 24 hours.

**10.** The photocurable composition according any of the claims 1 to 9, wherein the photocurable composition has an outgassing amount of 2000 $\mu m$ or less; wherein the outgasing is determined as described in the description.

**11.** A composition for encapsulation of an organic light emitting diode comprising the photocurable composition according to any one of claims 1 to 10.

**12.** An encapsulated apparatus, comprising:

a member for the apparatus; and
a barrier stack formed on the member for the apparatus, the barrier stack comprising an inorganic barrier layer and an organic barrier layer formed of the photocurable composition according to any one of claims 1 to 10.

**13.** The encapsulated apparatus according to claim 12, wherein the inorganic barrier layer is formed of any one of metals; nonmetals; oxides of metals, nonmetals or mixtures thereof; fluorides of metals, nonmetals or mixtures thereof; nitrides of metals, nonmetals or mixtures thereof; carbides of metals, nonmetals or mixtures thereof; oxynitrides of metals, nonmetals or mixtures thereof; borides of metals, nonmetals or mixtures thereof; silicides of metals, nonmetals or mixtures thereof; alloys of at least two metals; and alloys of metals and nonmetals, and wherein the metals is post transition metals, metalloids, transition metals or lanthanide metals.

**14.** The encapsulated apparatus according to claim 12 or 13, wherein the member for the apparatus comprises organic light emitting diodes, illumination devices, metal sensor pads, microdisc lasers, electrochromic devices, photochromic devices, microelectromechanical systems, solar cells, integrated circuits, charge coupled devices, or light emitting diodes.

**Patentansprüche**

**1.** Lichtaushärtbare Zusammensetzung, wobei, wenn A die Scherfestigkeit eines Glas-Metall-Legierung-Dies (Einheit: kgf) nach dem Aushärten zwischen einem Glassubstrat und einer Ni/Fe-Legierung anzeigt und B eine durch Gleichung 1 dargestellte Aushärtungsschrumpfung (Einheit: %) anzeigt, die lichtaushärtbare Zusammensetzung ein Verhältnis A/B von 0,7 kgf/% oder mehr und einen Wert A von 2,5 kgf oder mehr aufweist

<Gleichung 1>

Aushärtungsschrumpfung = [(spezifisches Gewicht einer festen lichtaushärtbaren Zusammensetzung nach dem Aushärten) - (spezifisches Gewicht einer flüssigen lichtaushärtbaren Zusammensetzung vor dem Aushärten)]/(spezifisches Gewicht der flüssigen lichtaushärtbaren Zusammensetzung vor dem Aushärten)×100,

und mit:

(A1) einem lichtaushärtbaren Monomer, das Phosphor (P) und Silizium (Si) enthält;
(A2) einem lichtaushärtbaren Monomer, das frei ist von Phosphor und Silizium und eine aromatische Gruppe enthält; und
(A3) einem lichtaushärtbaren Monomer, das frei ist von Phosphor, Silizium und einer aromatischen Gruppe,

wobei die Scherfestigkeit und die Aushärtungsschrumpfung wie in der Beschreibung dargestellt bestimmt werden.

2. Lichtaushärtbare Zusammensetzung nach Anspruch 1, wobei die lichtaushärtbare Zusammensetzung eine Aushärtungsschrumpfung von 1% oder mehr bis 10% oder weniger aufweist.

3. Lichtbare Zusammensetzung nach Anspruch 1 oder 2, wobei das lichtaushärtbare Monomer (A1) durch Formel 1 dargestellt ist:

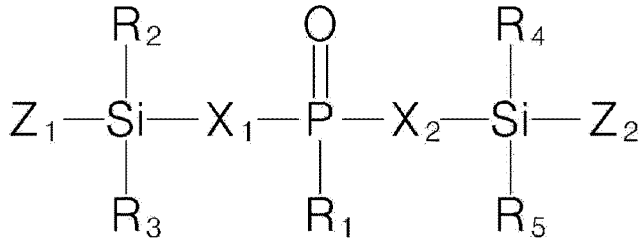

--- (Formel 1)

wobei in Formel 1 $X_1$ and $X_2$ jeweils unabhängig Sauerstoff, Schwefel oder - NR- sind (wobei R Wasserstoff oder eine $C_1$- bis $C_{10}$-Alkylgruppe ist);
$R_1$, $R_2$, $R_3$, $R_4$ und $R_5$ jeweils unabhängig eine substituierte oder unsubstituierte $C_1$ bis $C_{10}$-Alkylgruppe, eine substituierte oder unsubstituierte $C_6$- bis $C_{20}$-Arylgruppe, eine substituierte oder unsubstituierte $C_3$- bis $C_{10}$-Cykloalkylgruppe oder eine substituierte oder unsubstituierte $C_7$- bis $C_{21}$-A-rylalkylgruppe sind, und
$Z_1$ und $Z_2$ jeweils unabhängig Wasserstoff, eine substituierte oder unsubstituierte $C_1$ bis $C_{10}$-Alkylgruppe, eine substituierte oder unsubstituierte $C_6$- bis $C_{20}$-Arylgruppe, eine substituierte oder unsubstituierte $C_3$- bis $C_{10}$-Cykloalkylgruppe oder eine substituierte oder unsubstituierte $C_7$- bis $C_{21}$-A-rylalkylgruppe oder eine durch Formel 2 dargestellte Gruppe sind:

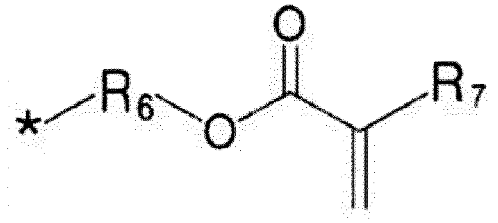

--- (Formel 2)

wobei "*" eine Bindungsstelle für Si darstellt, $R_6$ eine substituierte oder unsubstituierte $C_1$ bis $C_{10}$-Alkylengruppe, eine substituierte oder unsubstituierte $C_6$- bis $C_{20}$-Arylengruppe, eine substituierte oder unsubstituierte $C_3$- bis $C_{10}$-Cykloalkylengruppe oder eine substituierte oder unsubstituierte $C_7$- bis $C_{21}$-Arylalkylengruppe ist und $R_7$ Wasserstoff oder eine Methylgruppe ist, und
wobei mindestens eine der Komponenten $Z_1$ und $Z_2$ durch Formel 2 dargestellt ist.

4. Lichtaushärtbare Zusammensetzung nach einem der Ansprüche 1 bis 3, wobei das lichtaushärtbare Monomer (A2) durch Formel 5 dargestellt ist:

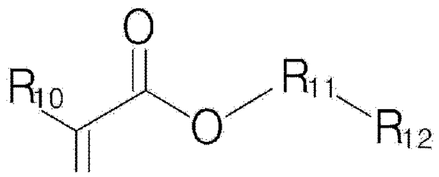

--- (Formel 5)

wobei in Formel 5 $R_{10}$ Wasserstoff oder eine Methylgruppe ist, $R_{11}$ eine substituierte oder unsubstituierte aliphatische $C_1$- bis $C_{10}$-Kohlenwasserstoffgruppe ist und $R_{12}$ eine substituierte oder unsubstituierte aromatische $C_6$- bis $C_{40}$-Kohlenwasserstoffgruppe ist.

**5.** Lichtaushärtbare Zusammensetzung nach einem der Ansprüche 1 bis 4, wobei das lichtaushärtbare Monomer (A3) ein Polyalkylenglycoldi(meth)acrylat aufweist.

**6.** Lichtaushärtbare Zusammensetzung nach einem der Ansprüche 1 bis 5, wobei die lichtaushärtbare Zusammensetzung aufweist: 1 Gew.-% bis 50 Gew.-% des lichtaushärtbaren Monomers (A1), 1 Gew.-% bis 50 Gew.-% des lichtaushärtbaren Monomers (A2) und 1 Gew.-% bis 90 Gew.-% des lichtaushärtbaren Monomers (A3).

**7.** Lichtaushärtbare Zusammensetzung nach einem der Ansprüche 1 bis 6, ferner mit einem Initiator (B).

**8.** Lichtaushärtbare Zusammensetzung nach einem der Ansprüche 1 bis 7, wobei die lichtaushärtbare Zusammensetzung aufweist: 1 Gew.-% bis 50 Gew.-% des lichtaushärtbaren Monomers (A1), 1 Gew.-% bis 50 Gew.-% des lichtaushärtbaren Monomers (A2), 1 Gew.-% bis 97 Gew.-% des lichtaushärtbaren Monomers (A3) und 0,1 Gew.-% bis 10 Gew.-% des Initiators (B).

**9.** Lichtaushärtbare Zusammensetzung nach einem der Ansprüche 1 bis 8, wobei die lichtaushärtbare Zusammensetzung eine Wasserdampfdurchlässigkeitsrate von 4,0 $g/m^2 \cdot 24h$ oder weniger aufweist, gemessen an einer 5 $\mu m$ dicken Überzugsschicht bei 37,8°C und 100% RH für 24 Stunden.

**10.** Lichtaushärtbare Zusammensetzung nach einem der Ansprüche 1 bis 9, wobei die lichtaushärtbare Zusammensetzung eine Ausgasungsmenge von 2000 ppm oder weniger aufweist, und wobei das Ausgasen wie in der Beschreibung dargestellt bestimmt wird.

**11.** Zusammensetzung zum Einkapseln einer organischen Leuchtdiode, die die lichtaushärtbare Zusammensetzung nach einem der Ansprüche 1 bis 10 aufweist.

**12.** Eingekapselte Vorrichtung mit:

einem Element für die Vorrichtung; und
einem Barrierestapel, der auf dem Element für die Vorrichtung ausgebildet ist, wobei der Barrierenstapel eine anorganische Barriereschicht und eine organische Barriereschicht aufweist, die aus der lichtaushärtbaren Zusammensetzung nach einem der Ansprüche 1 bis 2 hergestellt ist.

**13.** Eingekapselte Vorrichtung nach Anspruch 12, wobei die anorganische Barriereschicht aus einem der folgenden Materialien ausgebildet ist: Metallen; Nichtmetallen; Oxiden von Metallen, Nichtmetallen oder Mischungen davon; Fluoriden von Metallen, Nichtmetallen oder Mischungen davon; Nitriden von Metallen, Nichtmetallen oder Mischungen davon; Carbiden von Metallen, Nichtmetallen oder Mischungen davon; Oxynitriden von Metallen, Nichtmetallen oder Mischungen davon; Boriden von Metallen, Nichtmetallen oder Mischungen davon; Siliciden von Metallen, Nichtmetallen oder Mischungen davon; Legierungen aus mindestens zwei Metallen; und Legierungen aus Metallen und Nichtmetallen, und wobei die Metalle Nachübergangsmetalle, Metalloide, Übergangsmetalle oder Lanthanidmetalle sind.

**14.** Eingekapselte Vorrichtung nach Anspruch 12 oder 13, wobei das Element für die Vorrichtung organische Leuchtdioden, Beleuchtungsvorrichtungen, Metallsensorpads, Mikroscheibenlaser, elektrochrome Vorrichtungen, photochrome Vorrichtungen, mikroelektromechanische Systeme, Solarzellen, integrierte Schaltungen, ladungsgekoppelte Bauelemente oder Leuchtdioden aufweist.

## Revendications

**1.** Une composition photodurcissable, dans laquelle lorsque A indique la résistance à la compression sur cube d'un alliage verre-métal (unité : kgf) après durcissement entre un substrat en verre et un alliage Ni/Fe et B indique le rétrécissement au durcissement (unité : %) représentés par l'Equations 1, la composition photodurcissable a un A/B de 0,7 kgf/% et un A de 2,5 kgf ou plus.

<Equation 1>

Rétrécissement au durcissement = [(Gravité spécifique de la composition solide photodurcissable après durcissement)-(Gravité spécifique de la composition liquide photodurcissable avant durcissement)]/(Gravité spécifique de la composition liquide photodurcissable avant durcissement)x100.

et comprenant :

(A1) un monomère photodurcissable contenant du phosphore (P) et du silicium (Si) ;
(A2) un monomère photodurcissable ne contenant pas de phosphore et de silicium, et contenant un groupement aromatique; et
(A3) un monomère photodurcissable ne contenant pas de phosphore, de silicium et de groupement aromatique ; dans lequel la résistance à la compression et le rétrécissement au durcissement sont déterminés comme décrit dans la description.

**2.** La composition photodurcissable selon la revendication 1, dans laquelle la composition photodurcissable a un rétrécissement au durcissement de 1% ou plus haut à 10% ou plus bas.

**3.** La composition photodurcissable selon la revendication 1 ou 2, dans laquelle le monomère photodurcissable (A1) est représenté par la Formule 1 :

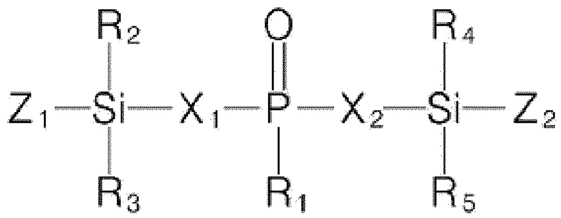

--- (Formule 1),

dans laquelle $X_1$ et $X_2$ sont chacun indépendamment un oxygène, un soufre, ou -NR-(où R est un hydrogène ou un groupement alkyle en $C_1$ à $C_{10}$) ;
$R_1$, $R_2$, $R_3$, $R_4$, et $R_5$ sont chacun indépendamment un groupement alkyle en $C_1$ à $C_{10}$ substitué ou non substitué, un groupement aryle en $C_6$ à $C_{20}$ substitué ou non substitué, un groupement cycloalkyle en $C_3$ à $C_{10}$ substitué ou non substitué, ou un groupement arylalkyle en $C_7$ à $C_{21}$ substitué ou non substitué ;
$Z_1$ et $Z_2$ sont chacun indépendamment un hydrogène, un groupement alkyle en $C_1$ à $C_{10}$ substitué ou non substitué, un groupement aryle en $C_6$ à $C_{20}$ substitué ou non substitué, un groupement cycloalkyle en $C_3$ à $C_{10}$ substitué ou non substitué, un groupement arylalkyle en $C_7$ à $C_{21}$ substitué ou non substitué, ou un groupement représenté par la Formule 2 :

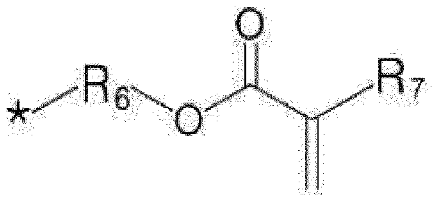

--- (Formule 2),

où « * » représente un site d'accroche pour Si, $R_6$ est un groupement alkylène en $C_1$ à $C_{10}$ substitué ou non substitué, un groupement arylène en $C_6$ à $C_{20}$ substitué ou non substitué, un groupement cycloalkylène en $C_3$ à $C_{10}$ substitué ou non substitué, ou un groupement arylalkylène en $C_7$ à $C_{21}$ substitué ou non substitué, et $R_7$ est un hydrogène ou un groupement méthyle ; et
au moins un de $Z_1$ et $Z_2$ est un groupement représenté par la Formule 2.

**4.** La composition photodurcissable selon l'une quelconque des revendications 1 à 3, dans laquelle le monomère

photodurcissable (A2) est représenté par la Formule 5 :

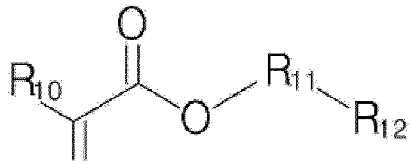

--- (Formule 5),

dans laquelle $R_{10}$ est un hydrogène ou un groupement méthyle ; $R_{11}$ est un groupement hydrocarboné aliphatique en $C_1$ à $C_{10}$ substitué ou non substitué ; et $R_{12}$ est un groupement hydrocarboné aromatique en $C_6$ à $C_{20}$ substitué ou non substitué.

**5.** La composition photodurcissable selon l'une quelconque des revendications 1 à 4, dans laquelle le monomère photodurcissable (A3) comprend un polyalkylène glycol di(méth)acrylate.

**6.** La composition photodurcissable selon l'une quelconque des revendications 1 à 5, dans laquelle la composition photodurcissable comprend : 1 wt% à 50 wt% du monomère photodurcissable (A1); 1 wt% à 50 wt% du monomère photodurcissable (A2) ; et 1 wt% à 90 wt% du monomère photodurcissable (A3).

**7.** La composition photodurcissable selon l'une quelconque des revendications 1 à 6, comprenant en outre : un initiateur (B).

**8.** La composition photodurcissable selon l'une quelconque des revendications 1 à 7, dans laquelle la composition photodurcissable comprend en outre : 1 wt% à 50 wt% du monomère photodurcissable (A1); 1 wt% à 50 wt% du monomère photodurcissable (A2) ; 1 wt% à 97 wt% du monomère photodurcissable (A3) ; et 0.1 wt% à 10 wt% de l'initiateur (B).

**9.** La composition photodurcissable selon l'une quelconque des revendications 1 à 8, dans laquelle la composition photodurcissable a un débit de transmission de vapeur d'eau de 4.0 $g/m^2 \cdot 24hr$ ou moins, mesuré sur une couche de revêtement épaisse de 5 $\mu m$ à 37°C et 100% RH pendant 24 heures.

**10.** La composition photodurcissable selon l'une quelconque des revendications 1 à 9, dans laquelle la composition photodurcissable a une quantité de dégazage de 2000 ppm ou moins ; où le dégazage est déterminé tel que décrit dans la description.

**11.** Une composition pour l'encapsulation d'une diode organique électroluminescente comprenant la composition photodurcissable selon l'une quelconque des revendications 1 à 10.

**12.** Un appareil encapsulé, comprenant :

un élément pour l'appareil ; et
un empilement de barrière formé sur l'élément de l'appareil, l'empilement de barrière comprenant une couche de barrière inorganique et une couche de barrière organique formées par la composition photodurcissable selon l'une quelconque des revendications 1 à 10.

**13.** L'appareil encapsulé selon la revendication 12, dans lequel la couche inorganique de barrière est formée par l'un quelconque de métaux ; non-métaux ; oxydes de métaux, non-métaux ou mélanges de ceux-ci ; fluorures de métaux, non-métaux et mélanges de ceux-ci ; nitrures de métaux, non-métaux et mélanges de ceux-ci ; carbures de métaux, non-métaux et mélanges de ceux-ci ; oxynitrures de métaux, non-métaux et mélanges de ceux-ci ; borures de métaux, non-métaux et mélanges de ceux-ci ; siliciures de métaux, non-métaux et mélanges de ceux-ci ; alliages d'au moins deux métaux ; et alliages de métaux et de non-métaux, et où les métaux sont des métaux de post-transition, des métalloïdes, des métaux de transition ou des métaux lanthanides.

**14.** L'appareil encapsulé selon la revendication 12 ou 13, dans lequel l'élément de l'appareil comprend une diode organique électroluminescente, des dispositifs d'éclairage, des détecteurs de mouvements métalliques, des lasers microdisques, des dispositifs électrochromiques, des dispositifs photochromiques, des systèmes microélectromécaniques, des cellules solaires, des circuits intégrés, des dispositifs couplés de charge, ou des diodes électroluminescentes.

FIG. 1

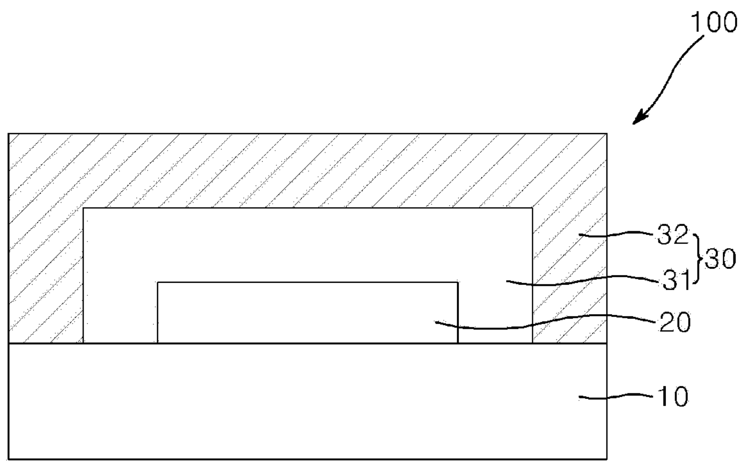


FIG. 2

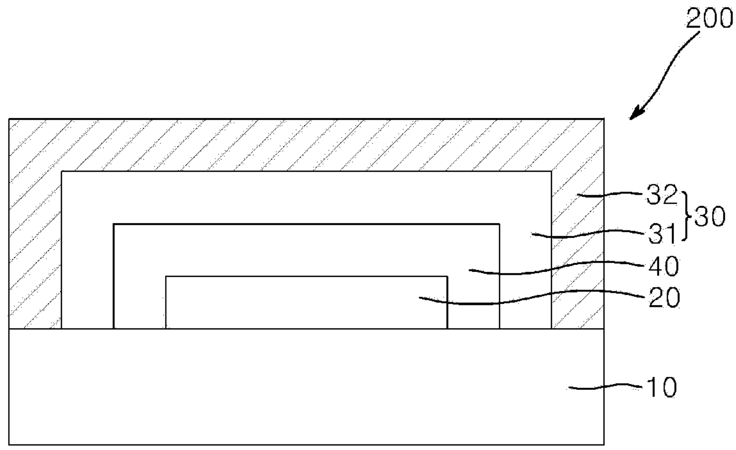

FIG. 3

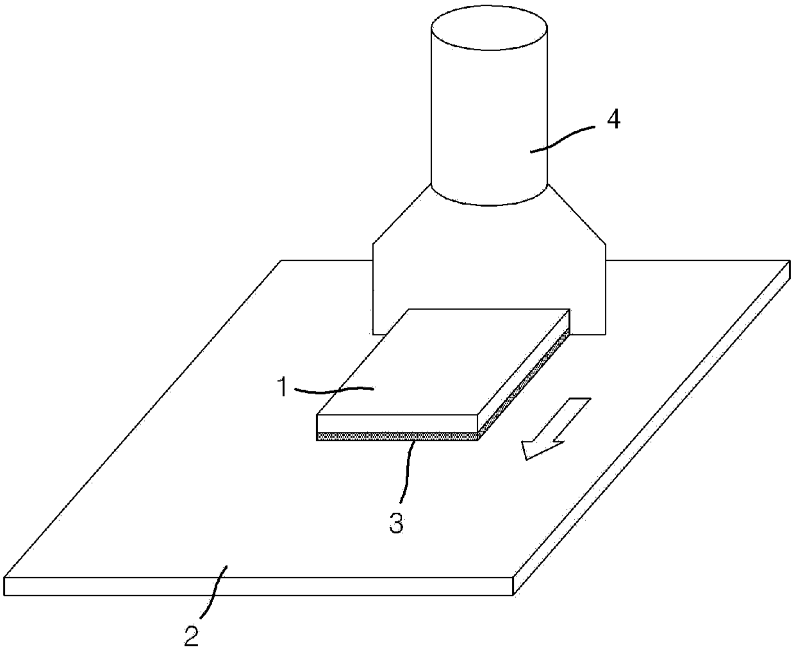


FIG. 4

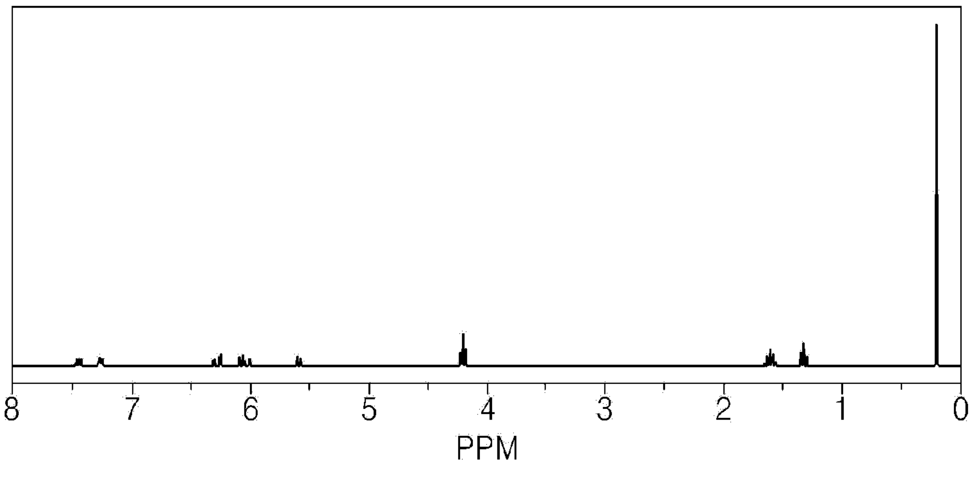

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 20050021054 A
- US 2010148666 A
- EP 2573854 A